(19) Europäisches Patentamt
European Patent Office
Office européen des brevets

(11) **EP 4 629 510 A1**

(12) **EUROPEAN PATENT APPLICATION**

(43) Date of publication:
08.10.2025 Bulletin 2025/41

(21) Application number: 25168233.2

(22) Date of filing: 03.04.2025

(51) International Patent Classification (IPC):
*H03K 17/0812* (2006.01)   *H03K 17/082* (2006.01)
*H03K 17/14* (2006.01)

(52) Cooperative Patent Classification (CPC):
**H03K 17/08126; H03K 17/0822; H03K 17/14;**
H03K 2017/0806

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 04.04.2024  IN 202411028005

(71) Applicant: Hamilton Sundstrand Corporation
Charlotte, NC 28217-4578 (US)

(72) Inventors:
• **CHANDAR, Apoorva**
**570017 Karnataka (IN)**
• **PRAKASH K, Jishnu**
**673655 Kerala (IN)**
• **KALIYANNAN ESWARAN, Pravinsharma**
**560064 Karnataka (IN)**

(74) Representative: **Casalonga**
**Casalonga & Partners**
**Bayerstraße 71/73**
**80335 München (DE)**

(54) **BASE-TO-EMITTER VOLTAGE TEMPERATURE COMPENSATION FOR TRANSISTOR INCLUDED IN SENSOR EXCITATION CIRCUIT**

(57)    A sensor excitation circuit includes a voltage driver circuit (102) and a short-circuit protection circuit (120). The voltage driver circuit (102) selectively conducts electrical current via a driver output in response to a first operating voltage exceeding a driver voltage threshold (V1be). The short-circuit protection circuit (120) includes a protection semiconductor switching device (122) and a temperature compensation circuit (130). The protection semiconductor switching device (122) limits the electrical current through the voltage driver circuit (102) in response to switching on when a second operating voltage exceeds a protection voltage threshold (V2be). The temperature compensation circuit (130) is connected to the protection semiconductor switching device (122), and is configured to limit a variation of the protection threshold voltage (V2be) in response to exposing the protection semiconductor switching device (122) to different temperatures.

FIG. 3

**Description**

CROSS-REFERENCE TO RELATED APPLICATIONS

This application claims the benefit of Indian Patent Application No. 202411028005 filed April 4, 2024.

BACKGROUND

Exemplary embodiments of the present disclosure generally relate to aerospace sensor systems, and more particularly, to a short-circuit protection circuit included in an aerospace sensor excitation circuit.

In aerospace applications, ensuring the integrity and reliability of sensor systems is crucial. Sensors such as Linear Voltage Differential Transformers (LVDTs), Resolvers, and load cell sensors are often implemented in sensor excitation circuits and typically operate within the excitation current ranges of 20 milliamps (mA) to 100 mA. The protection of these sensors from potential electrical short circuits is paramount, necessitating robust short circuit protection schemes. These short circuit protection schemes must be designed to maintain sensor integrity under various conditions, including the challenging aspect of temperature variations.

BRIEF DESCRIPTION

According to a non-limiting embodiment, a sensor excitation circuit includes a voltage driver circuit and a short-circuit protection circuit. The voltage driver circuit selectively conducts electrical current via a driver output in response to a first operating voltage exceeding a driver voltage threshold (V1be). The short-circuit protection circuit includes a protection semiconductor switching device and a temperature compensation circuit. The protection semiconductor switching device limits the electrical current through the voltage driver circuit in response to switching on when a second operating voltage exceeds a protection voltage threshold (V2be). The temperature compensation circuit is connected the protection semiconductor switching device, and is configured to limit a variation of the protection threshold voltage (V2be) in response to exposing the protection semiconductor switching device to different temperatures.

In addition to one or more of the features described above, or as an alternative to any of the foregoing embodiments, the protection semiconductor switching device includes a protection transistor.

In addition to one or more of the features described above, or as an alternative to any of the foregoing embodiments, the voltage driver circuit comprises a biasing circuit; and a driver semiconductor switching device including a driver control terminal connected to the biasing circuit and a driver output terminal configure to conduct the electrical current to a load.

In addition to one or more of the features described above, or as an alternative to any of the foregoing embodiments, the driver semiconductor switching device includes a driver transistor having a collector configured to receive a supply voltage, a base serving as the driver control terminal, and an emitter serving as the driver output.

In addition to one or more of the features described above, or as an alternative to any of the foregoing embodiments, the protection transistor comprises a collector connected to the base of the driver transistor; a base connected to the temperature compensation circuit and the emitter of the driver transistor; and an emitter connected to a ground reference point.

In addition to one or more of the features described above, or as an alternative to any of the foregoing embodiments, the temperature compensation circuit comprises a parallel resistor; and a negative temperature coefficient resistor (R-NTC) connected in parallel with the parallel resistor.

In addition to one or more of the features described above, or as an alternative to any of the foregoing embodiments, the temperature compensation circuit further comprises a series resistor connected in series with the parallel combination of the parallel resistor and the R-NTC.

In addition to one or more of the features described above, or as an alternative to any of the foregoing embodiments, the parallel resistor has a resistance value configured to set a current limit of the electrical current conducted through the driver transistor in response to switching on the protection transistor.

In addition to one or more of the features described above, or as an alternative to any of the foregoing embodiments, the R-NTC has a changing resistance that decreases with increasing temperature and which varies a resistance of the combination of the parallel resistor and the R-NTC in response to the changing resistance.

In addition to one or more of the features described above, or as an alternative to any of the foregoing embodiments, the parallel resistor has a first terminal connected in common with the base of the protection transistor, the second terminal of the second biasing resistor, the emitter of the driver transistor and a first terminal of the R-NTC, and has an opposing second terminal connected to a second terminal of the R-NTC and a first terminal of the series resistor.

In addition to one or more of the features described above, or as an alternative to any of the foregoing embodiments, the R-NTC has a first terminal connected in common with a first terminal of the parallel resistor, the base of the protection transistor, the second terminal of the second biasing resistor, and the emitter of the driver transistor, and has a second terminal connected in common with a second terminal of the parallel resistor and a first terminal of the series resistor.

In addition to one or more of the features described above, or as an alternative to any of the foregoing embodiments, the series resistor has an opposing second terminal connected to the emitter of the protection transistor, the series resistor configured to further limit the electrical current through the driver transistor to a target current level.

In addition to one or more of the features described above, or as an alternative to any of the foregoing embodiments, a combination of the parallel resistor and the series resistor set a short-circuit trip point of the protection transistor.

In addition to one or more of the features described above, or as an alternative to any of the foregoing embodiments, a short-circuit current limit on the driver output is set by an effective resistance established by a combination of a parallel sensing resistor (Rsense), a negative temperature coefficient resistor (R-NTC), and a series resistor (Rseries).

In addition to one or more of the features described above, or as an alternative to any of the foregoing embodiments, the biasing circuit is configured to set an operating point of the driver semiconductor switching device.

In addition to one or more of the features described above, or as an alternative to any of the foregoing embodiments, the biasing circuit includes a first biasing resistor and a second biasing resistor.

In addition to one or more of the features described above, or as an alternative to any of the foregoing embodiments, the first biasing resistor includes a first terminal connected to a first terminal of the second biasing resistor and includes an opposing second terminal connected to the base of the driver transistor.

In addition to one or more of the features described above, or as an alternative to any of the foregoing embodiments, the base of the driver transistor is connected to the second terminal of the first biasing resistor, and the emitter of the driver transistor is connected to a second terminal of the second biasing resistor.

BRIEF DESCRIPTION OF THE DRAWINGS

The following descriptions should not be considered limiting in any way. With reference to the accompanying drawings, like elements are numbered alike:

FIG. 1A illustrates a uni-polar sensor excitation circuit including a conventional short-circuit protection circuit;

FIG. 1B illustrates a bi-polar sensor excitation circuit including a conventional short-circuit protection circuit;

FIG. 2 is a graph depicting the effect variations in the base-emitter voltage (Vbe) of a protection transistor across different temperature has on the current limit of the protection transistor;

FIG. 3 illustrates a sensor excitation circuit including a short-circuit protection circuit according to a non-limiting embodiment of the present disclosure;

FIG. 4 is a graph comparing short-circuit current limit provided by a conventional short-circuit protection circuit compared to the short-circuit protection circuit according to a non-limiting embodiment of the present disclosure; and

FIG. 5 is a flow diagram illustrating a method of selecting values for the various components of the short-circuit protection circuit according to a non-limiting embodiment of the present disclosure.

DETAILED DESCRIPTION

A detailed description of one or more embodiments of the disclosed apparatus and method are presented herein by way of exemplification and not limitation with reference to the Figures.

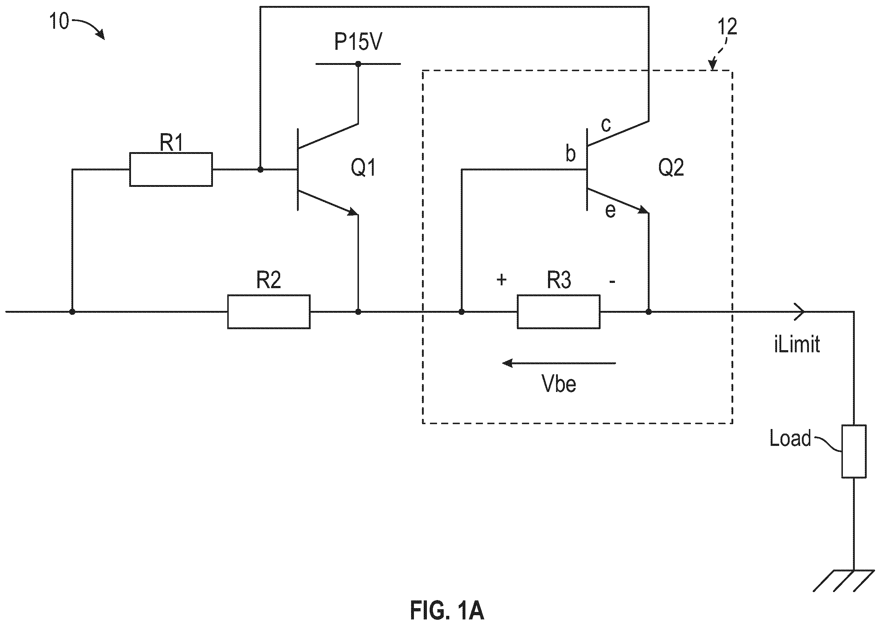

Traditional short-circuit protection schemes may involve implementing a short-circuit protection circuit, which implements a protection transistor (Q2) and a series protection resistor (R3) to control the excitation current provided to the sensor in fault conditions. Referring to FIG. 1A, a uni-polar excitation circuit 10 is shown including a conventional short-circuit protection circuit 12. The conventional short-circuit protection circuit 12 connects the series protection resistor (R3) across the base-emitter terminals of the protection transistor (Q2) to set a short-circuit current trip point. The conventional protection resistor-protection transistor arrangement determines the short-circuit current limit on the output ($i_{LIMIT}$) based on the voltage across the base and emitter of the protection transistor (Q2) and the value of the series protection resistor (R3). In the event of a short circuit, this configuration effectively grounds the input of the drive transistor (Q1), protecting the sensor from overcurrent damage, along with preventing overloading on the power rail.

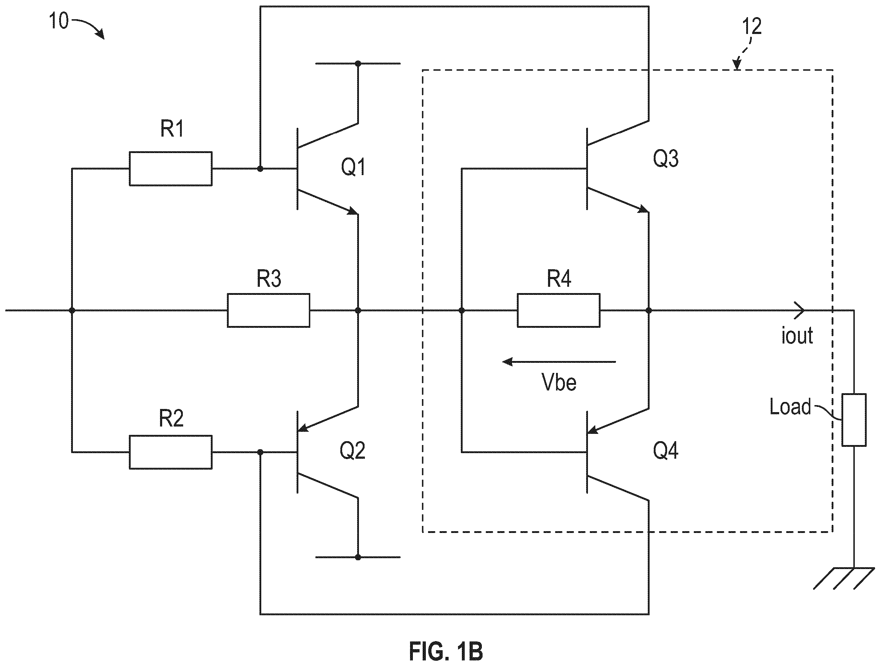

FIG. 1B illustrates bi-polar sensor excitation circuit including a conventional short-circuit protection circuit 12. In this configuration, Q1 and Q2 form a basic current mirror, where Q1's collector current, set by R1 and R3, is mirrored by Q2 to provide a constant current through R2 which is constant current is the reference for the rest of the circuit. Transistors Q3 and Q4, along with R4, form an active load for this current mirror, which could improve the output current's accuracy and allow for a higher output impedance. The Vbe across R4 ensures that Q3 and Q4 are in the active region, and the current through R4 is mirrored by Q4. When a short circuit occurs at the output ($i_{out}$), the voltage across R4 drops, reducing the base-emitter voltage (Vbe) of Q4. As Q4's base-emitter voltage decreases, it allows less current to flow through it, effectively limiting the current through the short circuit to a safe level. This mechanism provides a short circuit current limit function, protecting the circuit from excessive current that could otherwise damage components.

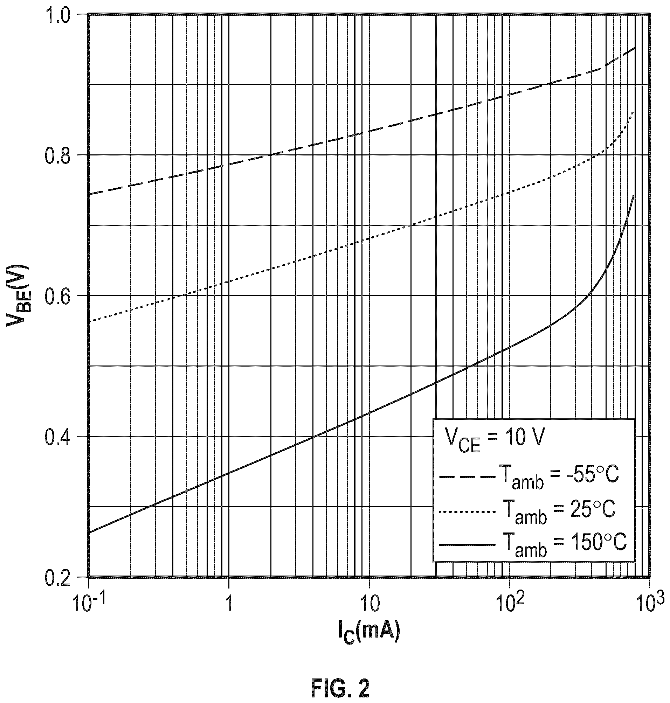

As shown in FIG. 2, however, the effectiveness of this protection circuit, is significantly influenced by the behavior of the transistor's threshold voltage (e.g., the base-emitter voltage, Vbe) across different temperatures, which in turn affects the current limit. This variability poses a challenge in maintaining consistent protection across the operational temperature range. For example, at negative 40 degrees Celsius (-40°C), the Vbe is set at 0.9 volts (V,) resulting in a current limit of 45mA. This setting is relatively high for colder conditions but ensures protection. At the standard operating temperature of 25°C, the Vbe decreases to 0.6V, adjusting the current limit to 30mA, which represents a balanced protection threshold under typical conditions. At higher temperatures, like 110°C, the Vbe further reduces to 0.3V, lowering the current limit to 15mA, thereby providing enhanced protection but potentially limiting sensor functionality.

The traditional approaches to implement short-circuit protections in aerospace sensor applications, which focuses on the adjustments in the transistor and resistor characteristics, highlights the intricacies of safeguarding sensor integrity. However, the significant temperature-induced variability in transistor's Vbe and the consequent adjustments in current limits underscore the challenges in achieving consistent protection levels. This underlines the critical need for the development of innovative short-circuit protection strategies that can adapt to temperature-induced variations, ensuring the reliable performance of aerospace sensors across a broad range of operational conditions.

Various non-limiting embodiments of the present disclosure address the short-comings discussed above by providing a short-circuit protection circuit capable of proving a threshold voltage temperature compensation for a protection semiconductor switching device utilized in a sensor excitation circuit. According to a non-limiting embodiment, the short-circuit protection circuit includes a temperature compensation circuit that operates to limit a variation of the threshold voltage (Vbe) of a protection transistor in response to exposing the protection transistor to different temperatures.

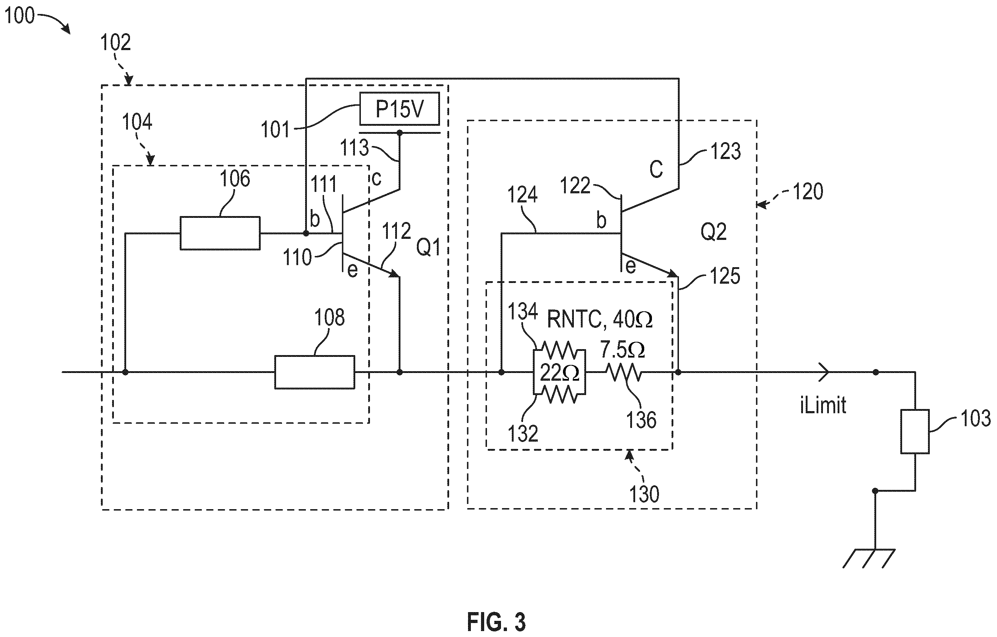

With reference now to FIG. 3, a sensor excitation circuit 100 is illustrated according to a non-limiting embodiment of the present disclosure. The sensor excitation circuit 100 includes a voltage driver circuit 102 and a short-circuit protection circuit 120. The voltage driver circuit 102 selectively conducts electrical current via a driver output in response to a first operating voltage exceeding a driver voltage threshold (V1be). The voltage driver circuit 102 includes a driver semiconductor switching device 110 and a biasing circuit 104. The driver semiconductor switching device 110 includes a driver control terminal 111 connected to the biasing circuit 104 and a driver output terminal 112 configure to conduct current to a load 103. The load 103 can include a sensor, for example, at which three scenarios can occur. A first scenario involves a failure of the load 103, which causes a short circuit condition the can fail and create short circuit condition. In a second scenario, the load 103 fails, causing an over-current condition. A third scenario involves the load 103 realizing an external short circuit in a cable harness or external connector.

According to a non-limiting embodiment, the driver semiconductor switching device 110 is implemented as a driver transistor 110, which includes a collector 113 configured to receive a supply voltage 101, a base 111 serving as the driver control terminal, and an emitter 112 serving as the driver output terminal. Accordingly, the driver semiconductor switching device 110 can operate to regulate an output of the driver circuit 102 based on the V1be.

The biasing circuit 104 is configured to set an operating point (e.g., the operating voltage) of the driver transistor 110. The biasing circuit 104 includes a first biasing resistor 106 and a second biasing resistor 108, the first biasing resistor 106 includes a first terminal connected to a first terminal of the second biasing resistor 108 and including an opposing second terminal connected to the base 111 of the driver transistor. A second terminal of the second biasing resistor 108 is connected to the emitter 112 of the driver transistor 110.

The short-circuit protection circuit 120 is connected to the voltage driver circuit 102. The short-circuit protection circuit 120 includes a short-circuit protection semiconductor switching device 122 and a temperature compensation circuit 130. The short-circuit protection semiconductor switching device 122 is switched on when its base-to-emitter voltage exceeds a protection voltage threshold (V2be). When switched on, the short-circuit protection semiconductor switching device 122 limits the electrical current through the voltage driver circuit 102. According to a non-limiting embodiment, the short-circuit protection semiconductor switching device 122 includes a collector 123 connected to the base 124 of the driver transistor 110, a base 124 connected to the temperature compensation circuit 130 and the emitter of the driver transistor 110, and an emitter 125 connected to a ground reference point.

The temperature compensation circuit 130 is connected to the protection semiconductor switching device 122. The temperature compensation circuit 130 limits the variation of the protection threshold voltage (V2be) that can occur when the protection semiconductor switching device 122 is exposed to different temperatures. The temperature compensation circuit 130 includes a parallel sensing resistor (Rsense) 132, a negative temperature coefficient resistor (R-NTC) 134 connected in parallel with the parallel sensing resistor (Rsense) 132, and a series resistor (Rseries) 136 connected in series with the parallel combination of the parallel sensing resistor 132 and the R-NTC 134. The parallel sensing resistor 132 can have a resistance ranging, for example, about 20 ohms (Ω) to about 25Ω. The R-NTC 134 can have a resistance ranging, for example, about 35Ω to about 45Ω. The series resistor 136 can have a resistance ranging, for example from about 6Ω to about 8Ω. It should be appreciated, however, that the value for the series resistor 136 can be set as any value based on the application of the sensor excitation circuit 100.

The effective resistance value of the combination of resistors 132, 134 and 136 sets the current limit of the current conducted through the driver transistor 112 and output from the driver circuit 102 in response to switching on the protection transistor 122. The parallel resistor 132 has a first terminal connected in common with the base 124 of the protection transistor 122, the second terminal of the second biasing resistor 108, the emitter 112 of the driver transistor 110 and a first terminal of the R-NTC 134. An opposing second terminal of the parallel resistor 132 is connected to a second terminal of the R-NTC 134 and a first terminal of the series resistor 136. Accordingly, the connection of the parallel resistor 132 across the base 124 and the emitter 125 sets the short-circuit trip point of the protection transistor 122.

The R-NTC 134 has a resistance that changes (e.g., decreases) in response to an increasing temperature. The changing resistance of the R-NTC 134 varies the default resistance of the parallel resistor 132. For example, when temperature rises the Vbe of the protection semiconductor switching device 122 decreases and hence the output current drops from nominal value. To compensate, the variation the R-NTC 134 added in parallel with the parallel resistor 132 and the series resistor 136. Hence the effective resistance decreases at higher temperature. This aids in maintaining the current limit closer to nominal value and can avoid enabling the current limit function at lower current. The same holds true for lower temperatures. In this manner, the current limit applied to the driver transistor 110 can be the same, or substantially the same, across all temperatures. According to a non-limiting embodiment, the R-NTC 134 has a first terminal connected in common with the first terminal of the parallel resistor 132, the base 124 of the protection transistor 122, the second terminal of the second biasing resistor 108, and the emitter 112 of the driver transistor 110.

The series resistor 136 has a first terminal connected in common with the second terminals of the parallel resistor 132 and the R-NTC 134. An opposing second terminal of the series resistor 136 is connected to ground. Accordingly, the series resistor 136 operates to further assist in limiting the current through the driver transistor 110 to a target current level (e.g., 30 mA).

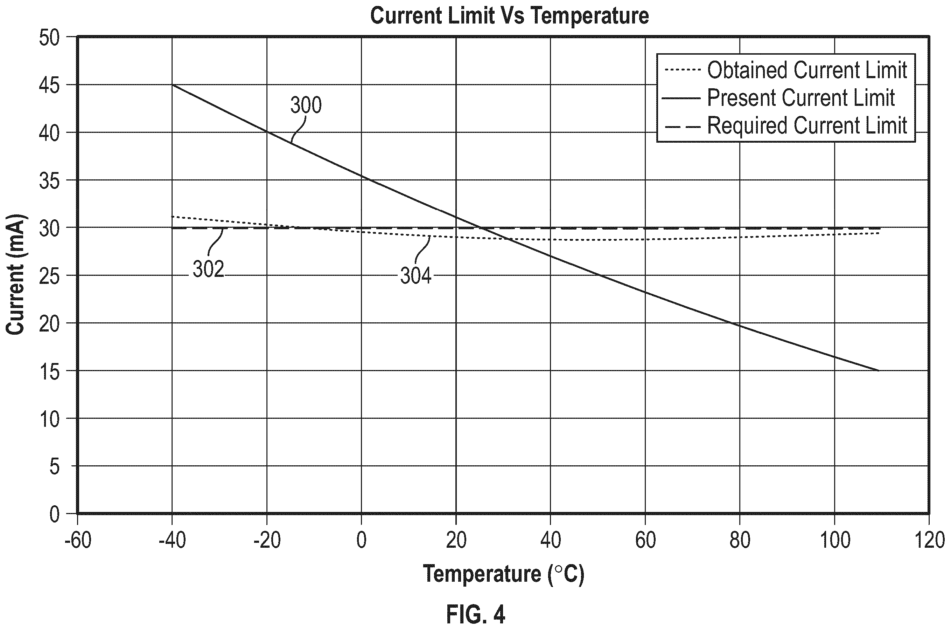

As shown in FIG. 4, the temperature compensation circuit 130 included in the short-circuit protection circuit 120 can prevent, or substantially prevent, variations in Vbe of the protection transistor 122. In this manner, the limit applied to current output from the voltage driver circuit 102 can be the same, or substantially the same, across all temperatures. The table below compares the current limit-vs-temperature values illustrated by the current limit-vs-temperature curve 300 provided by a conventional protection circuit (see FIG. 1) to the current limit-vs-temperature values illustrated by the current limit-vs-temperature curve 302 provided by the short-circuit protection circuit 120 according to non-limiting embodiments of the present disclosure.

| Temperature($^0$C) | RNTC value (Ohm) | Vbe of the Transistor(V) | Required R(Ohm) | Obtained R (Ohm) | Obtained current limit (mA) | Present current limit (mA) |
|---|---|---|---|---|---|---|
| -40 | 838.267 | 0.9 | 30 | 21.69 | 27.65 | 45 |
| 25 | 40 | 0.6 | 20 | 28.93 | 31.10 | 30 |
| 110 | 3.55 | 0.3 | 10 | 10.56 | 28.4 | 15 |

As shown in FIG. 4 and the table above, the conventional short-circuit protection circuit produces a current limit-vs-temperature curve 300 showing that it cannot meet the required resistances and current limits (e.g., 45mA, 30mA, and 15mA) illustrated by the required current limit-vs-temperature curve 302. However, the short-circuit protection circuit 120 according to various non-limiting embodiment of the present disclosure produces a current limit-vs-temperature curve 304 illustrating that current limits (27.65mA, 31.10mA, and 28.4mA) are achieved, which meet the required resistances and current limits illustrated by the target current limit-vs-temperature curve 302.

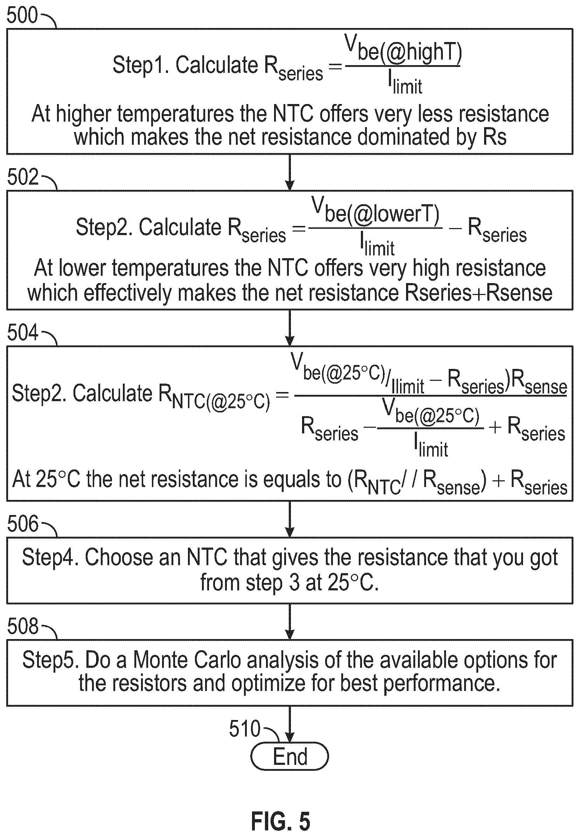

Turning now to FIG. 5, a method of selecting values for the various components of the short-circuit protection circuit 120 is illustrated according to a non-limiting embodiment of the present disclosure. At operation 500, the value of the series resistor 136 is determined. As described herein, the R-NTC 134 provides very little resistance at higher temperatures, which causes the net resistance to be effectively dominated by the series resistor (Rseries)136. Based on the application of the short-circuit protection circuit 120, the value of the series resistor 136 can be determined using the following equation:

$$Rseries = \frac{Vbe(@highT)}{I_{limit}}$$

At operation 502, the value of the parallel sensing resistor (Rsense) 132 is determined. As described herein, the R-NTC 134 provides very high resistance at lower temperatures, which causes the net resistance to be effectively determined as the combination of Rseries + Rsense. Based on the application of the short-circuit protection circuit 120, the value of Rsense 132 is determined can be determined using the following equation:

$$Rsense = \frac{Vbe(@lowT)}{I_{limit}} - Rseries$$

At operation 504, the value of the negative temperature coefficient resistor (R-NTC) 134 is determined. As described herein, the net resistance at low temperatures (e.g., 25 °C) can be defined as: (R-NTC//Rsense) + Rseries. Based on the application of the short-circuit protection circuit 120, the value of Rsense 132 is determined can be determined using the following equation:

$$R - NTC(@25°C) = \frac{(V_{be(@25°C)}/I_{limit} - R_{series})R_{sense}}{R_{sense} - \frac{V_{be\,(@25°C)}}{I_{limit}} + R_{series}}$$

At operation 506, an NTC (e.g., R-NTC) is selected that provides the resistance calculated at operation 504. At operation 508, a Monte Carlo analysis (also referred to as a Monte Carlo simulation) is performed to determine the available options for the resistors (e.g., 132, 124, 136), which optimizes the performance of the 100 for the given application, and the method ends at operation 510.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiment disclosed as the best mode contemplated for carrying out this present disclosure, but that the present disclosure will include all embodiments falling within the scope of the claims.

**Claims**

1. A sensor excitation circuit comprising:

   a voltage driver circuit (102) configured to selectively conduct electrical current via a driver output in response to a first operating voltage exceeding a driver voltage threshold (V1be); and
   a short-circuit protection circuit (120) connected to the voltage driver circuit (102), the short-circuit protection circuit (120) comprising:

   a protection semiconductor switching device (122) configured to limit the electrical current through the voltage driver circuit (102) in response to switching on when a second operating voltage exceeds a protection voltage threshold (V2be); and
   a temperature compensation circuit (130) connected to the protection semiconductor switching device (122),

wherein the temperature compensation circuit (130) is configured to limit a variation of the protection threshold voltage (V2be) in response to exposing the protection semiconductor switching device (122) to different temperatures.

2. The sensor excitation circuit of claim 1, wherein the protection semiconductor switching device (122) includes a protection transistor.

3. The sensor excitation circuit of claim 2, wherein the voltage driver circuit (102) comprises:

a biasing circuit (104); and
a driver semiconductor switching device (110) including a driver control terminal (111) connected to the biasing circuit (104) and a driver output terminal (112) configure to conduct the electrical current to a load (103).

4. The sensor excitation circuit of claim 3, wherein the driver semiconductor switching device (110) includes a driver transistor (110) having a collector (113) configured to receive a supply voltage, a base (111) serving as the driver control terminal (111), and an emitter (112) serving as the driver output.

5. The sensor excitation circuit of claim 4, wherein the protection transistor comprises:

a collector (123) connected to the base of the driver transistor;
a base (124) connected to the temperature compensation circuit (130) and the emitter of the driver transistor; and
an emitter (125) connected to a ground reference point.

6. The sensor excitation circuit of claim 5, wherein the temperature compensation circuit (130) comprises:

a parallel resistor (132); and
a negative temperature coefficient resistor, R-NTC (134), connected in parallel with the parallel resistor (132).

7. The sensor excitation circuit of claim 6, wherein the temperature compensation circuit (130) further comprises a series resistor (136) connected in series with a parallel combination of the parallel resistor (132) and the R-NTC (134).

8. The sensor excitation circuit of claim 7, wherein the parallel resistor (132) has a resistance value configured to control a current limit of the electrical current conducted through the driver transistor (112) in response to switching on the protection transistor (122).

9. The sensor excitation circuit of claim 8, wherein the R-NTC (134) has a changing resistance that decreases with increasing temperature and which varies a resistance of the combination of the parallel resistor (132) and the R-NTC (134) in response to the changing resistance.

10. The sensor excitation circuit of claim 9, wherein the parallel resistor (132) has a first terminal connected in common with the base (124) of the protection transistor, the second terminal of the second biasing resistor, the emitter (112) of the driver transistor and a first terminal of the R-NTC (134), and has an opposing second terminal connected to a second terminal of the R-NTC (134) and a first terminal of the series resistor (136).

11. The sensor excitation circuit of claim 10, wherein the R-NTC (134) has a first terminal connected in common with a first terminal of the parallel resistor (132), the base of the protection transistor, the second terminal of the second biasing resistor, and the emitter (112) of the driver transistor, and has a second terminal connected in common with a second terminal of the parallel resistor (132) and a first terminal of the series resistor (136).

12. The sensor excitation circuit of claim 11, wherein the series resistor (136) has an opposing second terminal connected to the emitter of the protection transistor, the series resistor (136) configured to further limit the electrical current through the driver transistor to a target current level.

13. The sensor excitation circuit of claim 12, wherein the parallel resistor (132) is connected across the base and the emitter of the protection transistor to set a short-circuit trip point of the protection transistor.

14. The sensor excitation circuit of claim 13, wherein a short-circuit current limit on the driver output is set by the protection voltage threshold (V2be) of the protection transistor and the resistance of the parallel resistor (132).

**15.** The sensor excitation circuit of claim 14, wherein the biasing circuit (104) is configured to set an operating point of the driver semiconductor switching device (110), and optionally wherein the biasing circuit (104) includes a first biasing resistor (106) and a second biasing resistor (108), and optionally wherein the first biasing resistor (106) includes a first terminal connected to a first terminal of the second biasing resistor (108) and includes an opposing second terminal connected to the base of the driver transistor, and optionally wherein the base of the driver transistor is connected to the second terminal of the first biasing resistor (106), and the emitter of the driver transistor is connected to a second terminal of the second biasing resistor (108).

FIG. 1A

FIG. 1B

FIG. 2

**FIG. 3**

EP 4 629 510 A1

FIG. 4

EP 4 629 510 A1

500

Step1. Calculate $R_{series} = \dfrac{V_{be(@highT)}}{I_{limit}}$

At higher temperatures the NTC offers very less resistance which makes the net resistance dominated by Rs

502

Step2. Calculate $R_{series} = \dfrac{V_{be(@lowerT)}}{I_{limit}} - R_{series}$

At lower temperatures the NTC offers very high resistance which effectively makes the net resistance Rseries+Rsense

504

Step2. Calculate $R_{NTC(@25°C)} = \dfrac{V_{be(@25°C)}/I_{limit} - R_{series})R_{sense}}{R_{series} - \dfrac{V_{be(@25°C)}}{I_{limit}} + R_{series}}$

At 25°C the net resistance is equals to $(R_{NTC}//R_{sense}) + R_{series}$

506

Step4. Choose an NTC that gives the resistance that you got from step 3 at 25°C.

508

Step5. Do a Monte Carlo analysis of the available options for the resistors and optimize for best performance.

510

End

FIG. 5

Europäisches
Patentamt

European
Patent Office

Office européen
des brevets

# EUROPEAN SEARCH REPORT

**Application Number**

EP 25 16 8233

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/041997 A1 (BALUJA WILFREDO FERNANDO [US]) 9 February 2023 (2023-02-09) * paragraphs [0023] - [0050]; figures 2-4 * | 1-15 | INV. H03K17/0812 H03K17/082 H03K17/14 |

- - - - -

**TECHNICAL FIELDS SEARCHED (IPC)**

H03K

The present search report has been drawn up for all claims

| Place of search | Date of completion of the search | Examiner |
|---|---|---|
| The Hague | 5 August 2025 | Meulemans, Bart |

EPO FORM 1503 03.82 (P04C01)

## ANNEX TO THE EUROPEAN SEARCH REPORT
## ON EUROPEAN PATENT APPLICATION NO.

EP 25 16 8233

This annex lists the patent family members relating to the patent documents cited in the above-mentioned European search report.
The members are as contained in the European Patent Office EDP file on
The European Patent Office is in no way liable for these particulars which are merely given for the purpose of information.

05-08-2025

| Patent document cited in search report | Publication date | Patent family member(s) | Publication date |
|---|---|---|---|
| US 2023041997 A1 | 09-02-2023 | CN 115706407 A | 17-02-2023 |
| | | EP 4131693 A2 | 08-02-2023 |
| | | US 2023041997 A1 | 09-02-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202411028005